(19) **Europäisches Patentamt**

**European Patent Office**

**Office européen des brevets**

(11) **EP 0 852 426 B1**

(12) **EUROPÄISCHE PATENTSCHRIFT**

(45) Veröffentlichungstag und Bekanntmachung des Hinweises auf die Patenterteilung:
**04.09.2002   Patentblatt 2002/36**

(51) Int Cl.⁷: **H03F 1/32**

(21) Anmeldenummer: **97120098.5**

(22) Anmeldetag: **17.11.1997**

(54) **Spannung-Strom- bzw. Strom-Strom-Umsetzer**

Voltage to current and current to current converter

Convertisseur tension/courant et courant/courant

(84) Benannte Vertragsstaaten:
**DE FR GB IT**

(30) Priorität: **09.12.1996   DE 19651081**

(43) Veröffentlichungstag der Anmeldung:
**08.07.1998   Patentblatt 1998/28**

(73) Patentinhaber: **Infineon Technologies AG**
**81669 München (DE)**

(72) Erfinder: **Rüschmann, Frank**
**81245 München (DE)**

(74) Vertreter: **Lange, Thomas, Dr. et al**
**Patentanwälte**
**Lambsdorff & Lange**
**Dingolfinger Strasse 6**
**81673 München (DE)**

(56) Entgegenhaltungen:
**EP-A- 0 669 710          US-A- 4 081 758**
**US-A- 5 497 123**

**Beschreibung**

Die Erfindung betrifft einen Umsetzer einer Eingangsgröße in einen Strom, d.h. einen Spannung-Strom- bzw. Strom-Strom-Umsetzer zum Umsetzen einer Eingangsspannung bzw. eines Eingangsstromes nach dem Oberbegriff des Anspruchs 1.

Spannung-Strom-Umsetzer sind aus EP 0 313 189 A2 durch einen Umsetzer mit einem Differenzverstärker zum Umsetzen einer Eingangsspannung in einen Ausgangsdifferenzstrom und aus EP 0 718 966 A1 durch einen Spannung-Stromumsetzer mit Emittereingängen bekannt. Sie werden in Systemen mit sehr großer Dynamik benötigt. Ein Beispiel für ein derartiges System ist die sogenannte Gilbert-Zelle, mit deren Hilfe aus zwei Eingangsfrequenzen $f_1$ und $f_2$ zwei Ausgangsfrequenzen $(f_1 + f_2)$ und $(f_1 - f_2)$ gemischt werden. Der kleinste Pegel in einem derartigen System ist durch das Rauschen bestimmt. Um eine große Dynamik zu erreichen, muß daher ein großer Maximalpegel verarbeitet werden, und die Spannung-Strom-Umsetzung mit hoher Linearität erfolgen, damit die Dynamik nicht durch Verzerrungen und Intermodulationen begrenzt wird.

Zu diesem Zweck werden bisher Differenzverstärker mit Stromgegenkopplung eingesetzt. Allerdings haben derartige Differenzverstärker einen hohen Rauschpegel, und eine direkte Einspeisung der Ausgangssignale des Differenzverstärkers als Eingangsströme in Mischstufen ist nur bedingt möglich, wobei insbesondere die Rückwirkungen der nichtlinearen Diodenkennlinien Verzerrungen bewirken. Ein weiterer Nachteil besteht darin, daß die maximale Eingangsspannung auf etwa 25 mV begrenzt ist. Werden beispielsweise zur Spannung-Strom-Umsetzung Differenzverstärker-Eingangsstufen verwendet, die durch Parallelschaltung mehrerer asymmetrischer Differenzverstärker linearisiert sind, so kann eine Eingangsspannung von maximal 40 mV erreicht werden.

Des weiteren ist ein Differenzverstärker bekannt, der in hochqualitativen FM-Übertragungssystemen eingesetzt wird und eine Eingangsstromdifferenz in eine Ausgangsstromdifferenz umsetzt. Um eine hohe Linearität zu erreichen, werden als Dioden geschaltete Transistoren verwendet, die jeweils zwischen den Basisanschlüssen der Transistoren des Differenzverstärkers und einem gemeinsamen Potential liegen, wobei die Basisanschlüsse der Differenzverstärker-Transistoren als Eingänge und die Kollektoranschlüsse der Differenzverstärker-Transistoren als Ausgänge dienen. Da der dynamische Widerstand zwischen den Eingangsleitungen nur geringfügig vom Eingangsstrom abhängt und klein gegenüber dem geforderten Eingangswiderstand ist, kann ein Vorwiderstand verwendet werden, um die Eingangsspannung in einen proportionalen Strom umzuformen.

Die Einspeisung erfolgt jedoch nicht aus einer Stromquelle. Bei dieser Konfiguration kann daher die Strom-Spannungs-Umsetzung nicht mit der erforderlichen Linearität durchgeführt werden. Mit anderen Worten, es wird zwar die Linearität der Kennlinie für die Umsetzung des Eingangsstromes verbessert, die Spannungsdifferenz zwischen den Eingangsanschlüssen ist jedoch weder konstant, noch folgt diese linear dem Eingangsstrom. Damit ist eine hochlineare Umwandlung einer Eingangsspannung in einen Eingangsstrom mit Hilfe eines Widerstandes nicht möglich.

In der den nächstliegenden Stand der Technik darstellenden Schrift EP 0 669 710 A2 ist ein Spannung-Strom-Umsetzer beschrieben, welcher eine verbesserte lineare Übertragungscharakteristik zwischen einer Eingangsspannung und einem Ausgangsdifferenzstrom aufweist. Dabei wirkt der Differenzverstärker mit einem Korrekturverstärker zusammen, dessen Übertragungscharakteristik invers zu der des Differenzverstärkers ist. Die Eingangsspannung liegt bei diesem Umsetzer an den Eingängen des Korrekturverstärkers an. Allerdings ist die dadurch erzielte Gesamtübertragungscharakteristik nur in einem Eingangsspannungs-Bereich von etwa - 200mV bis + 200mV annähernd linear.

Der Erfindung liegt die Aufgabe zugrunde, einen einfach aufgebauten Spannung-Strom- bzw. Strom-Strom-Umsetzer anzugeben, mit dem eine nahezu lineare Übertragung einer großen Eingangsspannung bzw. eines großen Eingangsstromes in einen Ausgangsdifferenzstrom möglich ist. Diese Aufgabe wird durch den Umsetzer mit den Merkmalen des Patentanspruchs 1 gelöst.

Dazu umfaßt der erfindungsgemäße Spannung-Strom- bzw. Strom-Strom-Umsetzer zum Umsetzen einer Eingangsspannung bzw. Eingangsstromes in einen Ausgangsdifferenzstrom mindestens einen Differenzverstärker, der wenigstens zwei Transistoren aufweist, und mindestens einen Korrekturverstärker, dessen Übertragungscharakteristik invers zu der des Differenzverstärkers ist. Dabei liegen die Ausgänge des Korrekturverstärkers an den Basisanschlüssen der Transistoren des Differenzverstärkers an. Die Emitter der Transistoren des Differenzverstärkers bilden die Eingänge des Umsetzers und sind mit den Eingängen des Korrekturverstärkers verbunden.

Mit dieser Schaltung kann eine ausgezeichnete Linearität der Umsetzung, d.h. der Übertragungscharakteristik, zwischen - 600 mV und + 600 mV erreicht werden. Aus der hohen Linearität erfolgt die Umwandlung des Eingangsstromes in den Ausgangsdifferenzstrom rauscharm, wobei weiterhin der Ausgangsdifferenzstrom vom Eingangsstrom entkoppelt ist. Ein derartiger Umsetzer eignet sich besonders gut für Systeme mit hoher Dynamik der eingangs beschriebenen Art, insbesondere zur Verwendung im Zusammenhang mit sogenannten Gilbert-Zellen.

In einer vorteilhaften Ausgestaltung der Erfindung weist der Korrekturverstärker mindestens zwei als Differenzverstärker geschaltete Transistoren und jeweils mindestens eine als linearer Lastwiderstand in die Kollektorzweige des Differenzverstärkers geschaltete Diode auf, die vorteilhafterweise durch als Dioden geschaltete Transistoren gebildet sind. Bei dieser Schaltungsanordnung wird eine Nicht-Linearität der Übertragungscharakteristik der Differenzverstärker-Transistoren durch die gegensinnig wirkenden NichtLinearitäten der Übertragungscharakteristik der Dioden und Transistoren des Korrekturverstärkers ausgeglichen, so daß die Übertragungscharakteristik der Schaltung insgesamt eine hohe Linearität aufweist.

Ein Vorteil im Hinblick auf die Vereinfachung der Schaltung besteht darin, daß die Eingangsdifferenzspannung am Differenzverstärker gleich Null ist. Damit genügt ein vor den Eingang geschalteter Widerstand, um eine Eingangsspannung linear in einen Eingangsstrom umzuwandeln.

Die Linearität der Übertragungscharakteristik kann in der Praxis noch verbessert werden, wenn mehrere Transistoren und Dioden in dem Korrekturverstärker parallel geschaltet werden, wobei die Anzahl vom verwendeten Transistortyp abhängt. Die Anzahl der im Differenz- und Korrekturverstärker parallel geschalteten Transistoren bestimmt das Übertragungsverhältnis $I_{in}$ zu $I_{out}$.

Um insbesondere Temperatureinflüsse auszuschalten, ist es vorteilhaft, wenn die Dioden und die Transistoren des Differenzverstärkers und des Korrekturverstärkers identisch auf einem Chip ausgebildet sind.

Schließlich eignet sich der erfindungsgemäße Umsetzer insbesondere zur Verwendung in Mischstufen und dabei in solchen Mischstufen, die Gilbert-Zellen verwenden. Daher ist eine vorteilhafte Ausgestaltung der Erfindung eine Mischstufe mit einer Gilbert-Zelle, bei der zwei Umsetzer der oben beschriebenen Art mit der Gilbert-Zelle zur Zufuhr der zu mischenden Frequenzen verbunden sind.

Ausführungsbeispiele der Erfindung werden nun anhand der beiliegenden Zeichnungen beschrieben. Es zeigen:

Fig. 1  ein Prinzipschaltbild eines Umsetzers nach einem Ausführungsbeispiel der Erfindung;

Fig. 2  eine graphische Darstellung der Übertragungscharakteristik und der ersten Ableitung der Übertragungscharakteristik des Umsetzers nach Fig. 1; und

Fig. 3  eine Mischstufe mit einer Gilbert-Zelle und zwei Umsetzern nach Fig. 1.

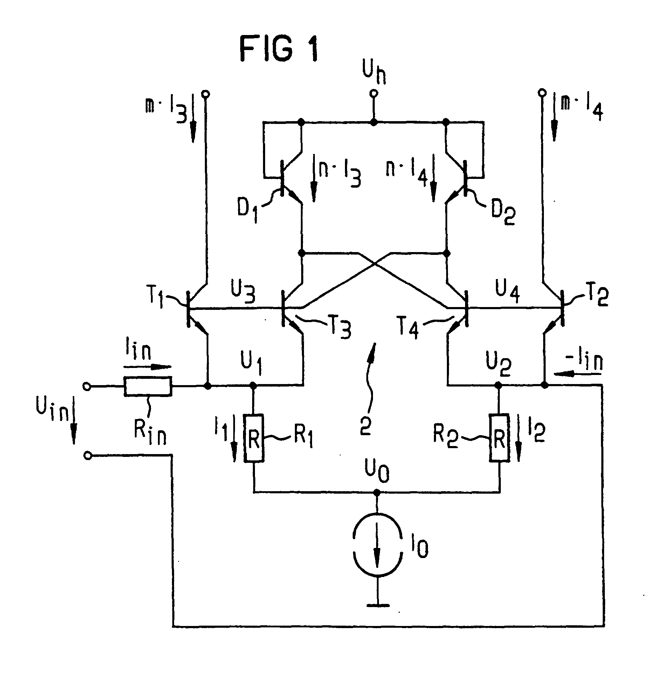

Der Spannung-Strom-Umsetzer nach Fig. 1 umfaßt einen Differenzverstärker $T_1$, $T_2$, dessen Emitteranschlüsse die Eingänge der Schaltung darstellen und dessen Basisanschlüsse auf einem Bezugspotential liegen (Differenzverstärker in Basisschaltung). Die Eingangsspannung $U_{in}$ wird über einen Widerstand $R_{in}$ in einen Eingangsstrom umgewandelt, der als $+I_{in}$ an dem Emitter des Transistors $T_1$ und als $-I_{in}$ an dem Emitter des Transistors $T_2$ anliegt. Die Emitter der beiden

Transistoren $T_1$ und $T_2$ sind über Widerstände $R_1$ bzw. $R_2$ mit Erde verbunden. Die Kollektoranschlüsse der Transistoren $T_1$ und $T_2$ bilden die Ausgänge der Schaltung.

Zwischen den Basisanschlüssen der Transistoren $T_1$ und $T_2$ des Differenzverstärkers ist ein Korrekturverstärker 2 angeordnet, dessen Übertragungscharakteristik invers zu der Differenzverstärkers mit den Transistoren $T_1$ und $T_2$ ist. Damit wird die Gesamtübertragungscharakteristik linear.

Der Korrekturverstärker 2 umfaßt zwei Transistoren $T_3$ und $T_4$, deren Basisanschlüsse mit den Basisanschlüssen der Transistoren $T_1$ bzw. $T_2$, sowie mit den Kollektoranschlüssen der Transistoren $T_4$ bzw. $T_3$ verbunden sind. Mit den Kollektoranschlüssen der Transistoren $T_3$ und $T_4$ sind Dioden $D_1$ bzw. $D_2$ verbunden, die aus als Dioden geschalteten Transistoren gebildet sind. Der Korrekturverstärker 2 weist somit mindestens zwei als Differenzverstärker geschaltete Transistoren $T_3$ und $T_4$ und mindestens zwei auf gemeinsamem Kathodenpotential liegende Dioden $D_1$, $D_2$ auf.

Jeweils eine Diode $D_1$, $D_2$, ein Transistor $T_3$, $T_4$ und ein Widerstand R sind in Serie geschaltet, wobei der Kollektoranschluß von einem Transistoren $T_3$ und $T_4$ jeweils mit der in Serie geschalteten Diode und dem Basisanschluß von einem der Transistoren $T_1$, $T_2$ des Differenzverstärkers und der Basis des anderen parallel geschalteten Transistors des Korrekturverstärkers verbunden sind.

Eine Simulation des Spannung-Strom-Umsetzers zeigt, daß ein sehr gutes Ergebnis im Bezug auf die Linearität der Übertragungscharakteristik dann erzielt wird, wenn die folgende Anzahl von Transistoren parallel geschaltet wird:

$T_1$, $T_2$:    1
$T_3$, $T_4$:    N = 4
$D_1$, $D_2$:    K = 6.

Hierbei ist das Verhältnis der Anzahl von $T_3$, $T_4$ und $D_1$, $D_2$ für eine Linearität des Umsetzers in der simulierten Technologie günstig. Je nach benötigter Übertragungscharakteristik von $I_{in}$ zu $I_3$-$I_4$ kann die Anzahl der für $T_1$ und $T_2$ bzw. für $T_3$ und $T_4$ verwendeten Transistoren verändert werden.

Für die folgende theoretische Ableitung wird angenommen, daß alle Transistoren vom selben Transistortyp sind, das die Transistoren $T_3$, $T_4$ aus n, die Transistoren $T_1$, $T_2$ aus m parallel geschalteten Transistoren und die Dioden $D_1$, $D_2$ aus k parallel geschalteten Dioden bestehen. Damit ergeben sich folgende Ausgangsgleichungen:

Der Strom in dem Widerstand $R_1$ beträgt:

$$1) \qquad I_1 = (m + n)\, I_3 + I_{in}$$

Der Strom in dem Widerstand $R_2$ beträgt:

$$2) \quad I_2 = (m + n) I_4 - I_{in}$$

Für die Ströme $I_3$ und $I_4$ ergibt sich ersichtlich:

$$3) \quad I_3 = I_S \cdot e^{\frac{U_3 - U_1}{U_T}}$$

$$4) \quad I_4 = I_S \cdot e^{\frac{U_4 - U_2}{U_T}}$$

Für die Spannungen $U_1$ bis $U_4$ ergeben sich ersichtlich aus der Figur folgende Gleichungen:

$$5) \quad U_1 = U_0 + R \cdot I_1$$

$$6) \quad U_2 = U_0 + R \cdot I_2$$

$$7) \quad U_3 = U_h - U_T \cdot \ln\left(\frac{\frac{n}{k}I_4}{I_S}\right)$$

$$8) \quad U_4 = U_h - U_T \cdot \ln\left(\frac{\frac{n}{k}I_3}{I_S}\right)$$

Aus den Gleichungen 5) und 1) bzw. aus den Gleichungen 6) und 2) errechnet sich $U_1$ bzw. $U_2$ wie folgt:

$$9) \quad U_1 = U_0 + R \cdot ((m + n)I_3 + I_{in})$$

$$10) \quad U_2 = U_0 + R \cdot ((m + n)I_4 - I_{in})$$

Daraus ergibt sich:

$$11) \quad U_1 - U_2 = (m + n)R \cdot (I_3 - I_4) + 2RI_{in}$$

$U_3$ gemäß Gleichung 7 - $U_4$ - gemäß Gleichung 8 ergibt:

$$12) \quad U_3 - U_4 = U_T \cdot \left(\ln\left(\frac{\frac{n}{k}I_3}{I_S}\right) - \ln\left(\frac{\frac{n}{k}I_4}{I_S}\right)\right)$$

Das Verhältnis von $I_3$ durch $I_4$ ergibt sich aus einer Division der Werte für $I_3$ und $I_4$ aus den Gleichungen 3 und 4 wie folgt:

$$13) \quad \frac{I_3}{I_4} = \frac{e^{\frac{U_3 - U_4}{U_T}}}{e^{\frac{U_1 - U_2}{U_T}}} = \frac{\frac{\frac{n}{k}I_3}{I_S} \cdot \frac{I_S}{\frac{n}{k}I_4}}{e^{(m+n)R \cdot (I_3 - I_4)} \cdot e^{2RI_{in}}}$$

Daraus folgt:

$$14) \quad 1 = e^{(m+2)R \cdot (I_3 - I_4) + 2RI_{in}}$$

sowie

$$15) \quad 0 = (m + n)R \cdot (I_3 - I_4) + 2RI_{in}$$

Unter der Annahme, daß R > 0 ist, was bei der gezeigten Schaltung ohnehin der Fall ist, gilt:

$$16) \quad I_{in} = \frac{1 + n}{2} (I_4 - I_3)$$

Die Gleichung 16 zeigt, daß die Differenz der Ausgangsströme proportional zum Eingangsstrom ist.
Um die Eingangsspannung $u_{in}$ in eine proportionale Ausgangsstromdifferenz $I_4 - I_3$ umsetzen zu können, wird die Eingangsspannung $u_{in}$ erst durch den Eingangswiderstand $R_{in}$ in einen proportionalen Eingangsstrom $I_{in}$ umgeformt. Diese Umsetzung erfolgt gemäß der Gleichung 17):

$$17) \quad U_{in} = I_{in} \cdot R_{in} + (U_1 - U_2)$$

Damit die Umformung der Proportionalitätsbedingung

$$U_{in} = I_{in} \cdot R_{in} + \text{Konstante}$$

genügt, muß $U_1 - U_2$ konstant, besser aber 0 sein. Es gilt:

$$18) \quad U_1 - U_2 = (I_1 \cdot R) - (I_2 \cdot R)$$

Unter der Annahme, daß R > 0 gilt, ergibt sich folgendes:

$$19) \quad I_1 - I_2 = (m + n)I_3 + I_{in} - ((m + n)I_4 - I_{in})$$

$$= (m + n)I_3 - (m + n)I_4 + 2I_{in}$$

Setzt man in diese Gleichung das Ergebnis von Gleichung 16) ein, ergibt sich unmittelbar:

$$20) \quad I_1 - I_2 = 0$$

Eingesetzt in 18) ergibt:

$$21) \quad U_1 - U_2 = (I_1 - I_2)R = O \text{ mit } R > O$$

Damit ist gezeigt, daß der Spannung-Strom-Umsetzer eine lineare Übertragungsfunktion für die Umsetzung eines Eingangsstromes bzw. einer Eingangsspannung in die Differenz der Ausgangsströme aufweist.

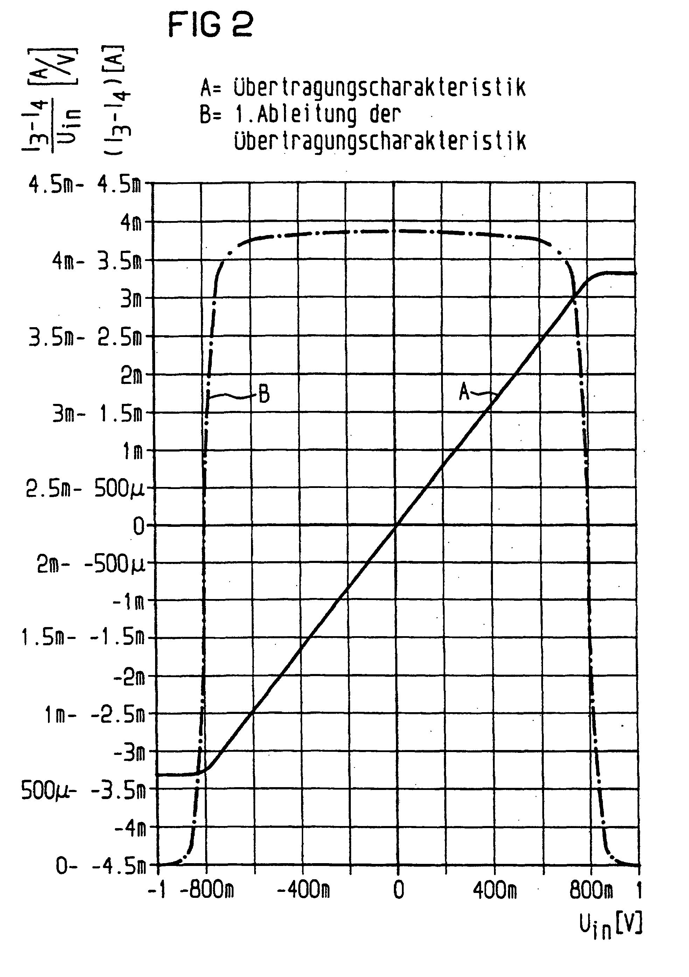

Dieses Ergebnis ergibt sich auch aus Fig. 2, in der als Kurve A die Übertragungscharakteristik $(I_3 - I_4)/U_{in}$ und als Kurve B die erste Ableitung der Übertragungscharakteristik

$$\frac{d\frac{(I_3 - I_4)}{u_{in}}}{du_{in}}$$

gezeigt ist. Die Kurve A hat ersichtlich zwischen - 600 mV und + 600 mV eine hohe Linearität. Dies wird auch durch die erste Ableitung der Übertragungscharakteristik in Kurve B demonstriert, die in diesem Bereich mit großer Annäherung konstant ist.

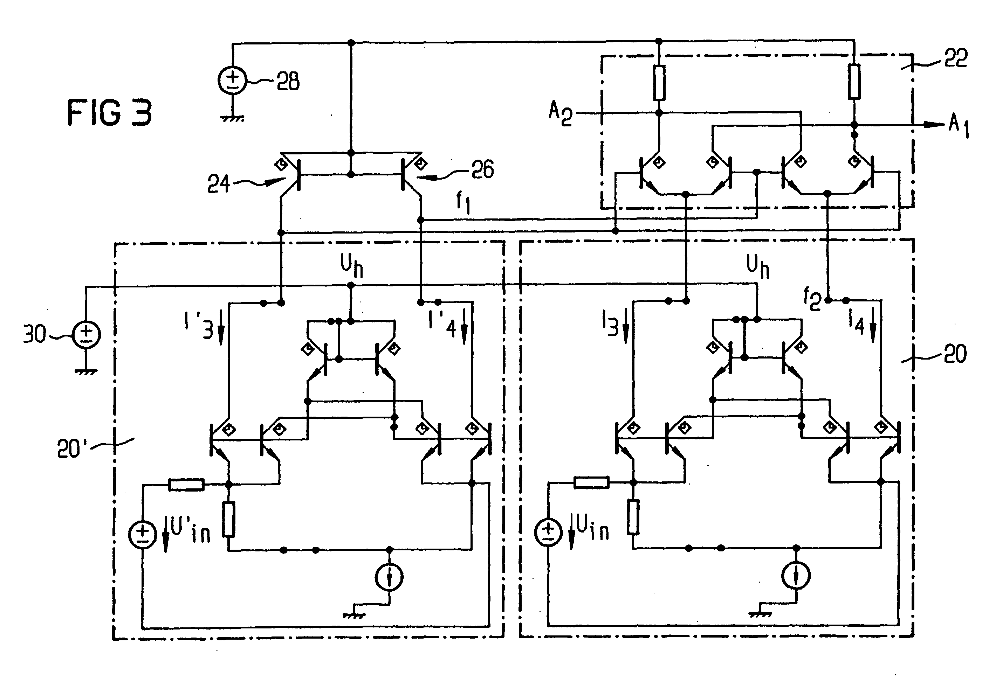

Fig. 3 zeigt eine Schaltung, bei der zwei Spannung-Strom-Umsetzer 20, 20' in Verbindung mit einer Gilbert-Zelle 22 vorgesehen sind. Die Eingangsspannungen an den Umsetzern 20, 20' sind $U_{in}$ und $U'_{in}$. Die Ausgangsstromdifferenzen $(I_3 - I_4)$ und $(I_3' - I_4')$ mit den Frequenzen $F_1$ bzw. $F_2$ werden an die entsprechenden Eingänge der Gilbert-Zelle 22 gegeben. An den Ausgängen $A_1$, $A_2$ der Gilbert-Zelle stehen Signale mit den Frequenzen $(F_1 - F_2)$ und $(F_1 + F_2)$ an. Die Ausgänge des Umsetzers 20' sind über zwei als Dioden geschaltete Transistoren 24, 26 an einer Batteriespannungsquelle 28 angeschlossen, die auch die Vorspannung für die Gilbert-Zelle 22 liefert. Eine weitere Spannungsquelle 30 liefert die Vorspannung UH für die beiden Umsetzer 20, 20'.

Die in Fig. 3 gezeigte Schaltung ist ein Beispiel dafür, daß die Spannung-Strom-Umsetzer vorteilhaft eingesetzt werden können, wenn es um die Linearität bei Umsetzung von einer Eingangsspannung in Ausgangsstromdifferenzen geht.

Selbstverständlich kann der erfindungsgemäße Spannung-Strom-Umsetzer auch bei anderen Anwendung in vorteilhafter Weise eingesetzt werden, bei denen es um eine hohe Dynamik, die Verarbeitung hoher Eingangsspannungen, beispielsweise größer als 40 mV, und die oben beschriebenen Kriterien geht.

**Patentansprüche**

1. Umsetzer zum Umsetzen einer Eingangsgröße in einen Ausgangsdifferenzstrom, mit mindestens einem Differenzverstärker, der wenigstens zwei Transistoren ($T_1$, $T_2$) aufweist, und mindestens einem Korrekturverstärker (2), dessen Übertragungscharakteristik invers zu der des Differenzverstärkers ($T_1$, $T_2$) ist und dessen Ausgänge an den Basisanschlüssen der Transistoren ($T_1$, $T_2$) des Differenzverstärkers anliegen, **dadurch gekennzeichnet, daß** die Emitter der Transistoren ($T_1$, $T_2$) des Differenzverstärkers die Eingänge des Umsetzers bilden und mit den Eingängen des Korrekturverstärkers (2) verbunden sind.

2. Umsetzer nach Anspruch 1, bei dem die Eingangsgröße eine Spannung oder ein Strom ist.

3. Umsetzer nach Anspruch 2, bei dem der Korrekturverstärker (2) mindestens zwei als Differenzverstärker geschaltete Transistoren ($T_3$, $T_4$) und jeweils mindestens eine als nichtlinearer Lastwiderstand in die Kollektorzweige der Transistoren des Korrekturverstärkers geschaltete Diode ($D_1$, $D_2$) aufweist.

4. Umsetzer nach Anspruch 3, bei dem jeweils eine Diode ($D_1$, $D_2$ ), ein Transistor ($T_3$, $T_4$) des Korrekturverstärkers und ein Widerstand (R) in Serie geschaltet sind, wobei der Kollektoranschluß von einem der Transistoren ($T_3$, $T_4$) jeweils mit der in Serie geschalteten Diode ($D_1$, $D_2$), dem Basisanschluß von einem der Transistoren ($T_1$, $T_2$) des Differenzverstärkers und dem Basisanschluß des anderen Transistors ($T_3$, $T_4$) des Korrekturverstärkers (2) verbunden sind.

5. Umsetzer nach Anspruch 1, bei dem am Eingang ein Widerstand ($R_{in}$) angeordnet ist, der die Eingangsspannung ($U_{in}$) linear in einem Eingangsstrom ($I_{in}$) umwandelt.

6. Umsetzer nach einem der vorhergehenden Ansprüche, bei dem jeweils mehrere Dioden ($D_1$, $D_2$) und mehrere Transistoren ($T_1$, $T_2$, $T_3$, $T_4$) parallel geschaltet sind.

7. Umsetzer nach einem der vorhergehenden Ansprüche, bei dem die Dioden ($D_1$, $D_2$), die Transistoren ($T_1$, $T_2$) des Differenzverstärkers und die Transistoren ($T_3$, $T_4$) des Korrekturverstärkers identisch auf einem Chip ausgebildet sind.

8. Mischstufe mit einer Gilbert-Zelle, bei der zwei Umsetzer nach einem der Ansprüche 1 bis 6 mit der Gilbert-Zelle (22) zur Zufuhr der zu mischenden Frequenzen verbunden sind.

**Claims**

1. Converter for conversion of an input variable to an output difference current,
   having at least one differential amplifier which has at least two transistors ($T_1$, $T_2$), and having at least one correction amplifier (2), whose transmission characteristic is the inverse of that of the differential amplifier ($T_1$, $T_2$) and whose outputs are connected to the base connections of the transistors ($T_1$, $T_2$) of the differential amplifier,
   **characterized**
   **in that** the emitters of the transistors ($T_1$, $T_2$) of the differential amplifier form the inputs of the converter, and are connected to the inputs of the correction amplifier (2).

2. Converter according to Claim 1, in which the input variable is a voltage or a current.

3. Converter according to Claim 2, in which the correction amplifier (2) has at least two transistors ($T_3$, $T_4$), which are connected as a differential amplifier, and in each case at least one diode ($D_1$, $D_2$), which is connected as a nonlinear load resistance in the collector paths of the transistors of the correction amplifier.

4. Converter according to Claim 3, in which in each case one diode ($D_1$, $D_2$), one transistor ($T_3$, $T_4$) of the correction amplifier and a resistor (R) are connected in series, with the collector connection of one of the transistors ($T_3$, $T_4$) in each case being connected to the series-connected diode ($D_1$, $D_2$), to the base connection of one of the transistors ($T_1$, $T_2$) of the differential amplifier, and to the base connection of the other transistor ($T_3$, $T_4$) of the correction amplifier (2).

5. Converter according to Claim 1, in which a resistor ($R_{in}$) is arranged at the input and converts the input voltage ($U_{in}$) linearly to an input current ($I_{in}$).

6. Converter according to one of the preceding claims, in which a number of diodes ($D_1$, $D_2$) and a number of transistors ($T_1$, $T_2$, $T_3$, $T_4$) are in each case connected in parallel.

7. Converter according to one of the preceding claims, in which the diodes ($D_1$, $D_2$), the transistors ($T_1$, $T_2$) of the differential amplifier and the transistors ($T_3$, $T_4$) of the correction amplifier are in an identical form on one chip.

8. Mixing stage having a Gilbert cell, in which two converters according to one of Claims 1 to 6 are connected to the Gilbert cell (22) in order to supply the frequencies to be mixed.

**Revendications**

1. Convertisseur pour la conversion d'une grandeur d'entrée en un courant différentiel de sortie,
   ayant au moins un amplificateur différentiel, qui comporte au moins deux transistors ($T_1$, $T_2$), et ayant au moins un amplificateur correcteur (2) dont la caractéristique de transmission est l'inverse de celle de l'amplificateur différentiel ($T_1$, $T_2$) et dont les sorties se trouvent aux bases des transistors ($T_1$, $T_2$) de l'amplificateur différentiel,
   **caractérisé par le fait que**
   les émetteurs des transistors ($T_1$, $T_2$) de l'amplificateur différentiel forment les entrées du convertisseur et sont reliés aux entrées de l'amplificateur correcteur (2).

2. Convertisseur selon la revendication 1, dans lequel la grandeur d'entrée est une tension ou un courant.

3. Convertisseur selon la revendication 2, dans lequel l'amplificateur correcteur (2) comporte au moins deux transistors ($T_3$, $T_4$) branchés comme amplificateur différentiel et respectivement au moins une diode ($D_1$, $D_2$) branchée comme résistance de charge non linéaire dans les branches de collecteurs des transistors de l'amplificateur correcteur.

4. Convertisseur selon la revendication 3, dans lequel, respectivement, une diode ($D_1$, $D_2$), un transistor ($T_3$, $T_4$) de l'amplificateur correcteur et une résistance (R) sont branchés en série, le collecteur de l'un des transistors ($T_3$, $T_4$) étant relié respectivement à la diode ($D_1$, $D_2$) branchée en série, à la base de l'un des transistors ($T_1$, $T_2$) de l'amplificateur différentiel et à la base de l'autre transistor ($T_3$, $T_4$) de l'amplificateur correcteur (2).

5. Convertisseur selon la revendication 1, dans lequel il y a à l'entrée une résistance ($R_{in}$) qui transforme linéairement la tension d'entrée ($U_{in}$) en un courant d'entrée ($I_{in}$).

6. Convertisseur selon l'une des revendications précédentes, dans lequel, respectivement, plusieurs diodes ($D_1$, $D_2$) et plusieurs transistors ($T_1$, $T_2$, $T_3$, $T_4$) sont branchés en parallèle.

7. Convertisseur selon l'une des revendications précédentes, dans lequel les diodes ($D_1$, $D_2$), les tran-

sistors ($T_1$, $T_2$) de l'amplificateur différentiel et les transistors ($T_3$, $T_4$) de l'amplificateur correcteur sont conçus à l'identique sur une puce.

8. Etage mélangeur avec une cellule de Gilbert, dans lequel deux convertisseurs selon l'une des revendications 1 à 6 sont reliés à la cellule de Gilbert (22) pour l'amenée des fréquences à mélanger.

# FIG 1

# FIG 2

A= Übertragungscharakteristik
B= 1.Ableitung der
   Übertragungscharakteristik

FIG 3